# EUROPÄISCHE PATENTSCHRIFT

(11) **EP 1 464 080 B1**
(45) Veröffentlichungstag und Bekanntmachung des Hinweises auf die Patenterteilung: **05.09.2007**
(21) Anmeldenummer: 03729462.6
(22) Anmeldetag: 15.01.2003
(51) Int. Cl.: H01L 21/98

(54) **VERFAHREN ZUR HERSTELLUNG EINER VERBUNDVORRICHTUNG**
METHOD FOR PRODUCTION OF A BONDING DEVICE
PROCEDE POUR PRODUIRE UN DISPOSITIF D'INTERCONNEXION

(30) Priorität: 18.01.2002 DE 10201881; 22.08.2002 DE 10238587
(43) Veröffentlichungstag der Anmeldung: 06.10.2004
(73) Patentinhaber: Fraunhofer-Gesellschaft zur Förderung der angewandten Forschung e.V., 80686 München (DE)
(72) Erfinder: BOCK, Karlheinz, 82110 Germering (DE); KÖNIG, Martin, 81475 München (DE)
(74) Vertreter: Schoppe, Fritz
(86) Internationale Anmeldenummer: PCT/EP2003/000359
(87) Internationale Veröffentlichungsnummer: WO 2003/060995

(56) Entgegenhaltungen:
- EP-A- 0 491 059
- WO-A-96/32841
- WO-A-98/28320
- US-A- 5 075 253
- US-A- 5 545 291
- US-A1- 2002 005 294
- US-A1- 2003 062 123
- US-B1- 6 265 021
- US-B1- 6 291 266
- US-B1- 6 379 699
- MIRKIN C A ET AL: "A DNA-BASED METHOD FOR RATIONALLY ASSEMBLING NANOPARTICLES INTO MACROSCOPIC MATERIALS" NATURE, MACMILLAN JOURNALS LTD. LONDON, GB, Bd. 382, Nr. 6592, 15. August 1996 (1996-08-15), Seiten 609-611, XP001092721 ISSN: 0028-0836

## Beschreibung

Die vorliegende Erfindung bezieht sich auf ein Verfahren zur Herstellung einer Verbundvorrichtung, wobei zwei Bauelemente mechanisch miteinander verbunden werden.

Zur Montage von mikroelektronischen, mikromechanischen und vielen anderen Bauteilen auf einem Substrat sind verschiedene Aufbau- und Verbindungstechniken bekannt. Die gängigsten Techniken sind das Die-Bonden, das Draht-Bonden, das Flipchip-Bonden sowie isoplanare Verbindungstechniken.

Das Die-Bonden ist in der Regel eine Vorstufe für Draht- oder isoplanare Verbindungstechniken. Beim Die-Bonden wird ein Bauteil mit einem Klebstoff auf einer Substratoberfläche montiert. Elektrische Verbindungen werden danach mittels Draht- oder isoplanaren Verbindungstechniken hergestellt.

Bei der Draht-Bond-Technik werden zur Herstellung von elektrischen Verbindungen Gold-, Aluminium- oder Silberdrähte verwendet.

Bei der isoplanaren Verbindungstechnik bzw. der isoplanaren Kontaktierung wird ein leitfähiger Klebstoff verwendet.

Für das Flipchip-Verfahren, das in der Regel für Halbleiterbauelemente verwendet wird, werden Anschlußflächen an einer Oberfläche des Bauelements beispielsweise mit Bumps bzw. Kontakthügeln versehen. Für die weit verbreitete Lötmontage werden die Anschlußflächen mit Lotkugeln versehen. Diese werden bei der Montage aufgeschmolzen, benetzen die Substratkontakte und bilden nach dem Abkühlen und Erstarren mechanische und elektrisch leitfähige Metallverbindungen zwischen den Anschlußflächen des Bauelements und den Substratkontakten. Um die Zuverlässigkeit der Verbindung zu verbessern, wird nach dem Lötvorgang der Spalt zwischen Substrat und Bauelement bzw. Chip mit einer Vergußmasse (Underfiller) aufgefüllt.

Aus Kostengründen finden Flipchip-Verbindungstechniken unter Verwendung von Klebstoffen zunehmende Verbreitung. Dazu zählen:
- Die Flipchip-Verbindungstechnik mit Leitkleber und Vergußmasse, bei der zunächst durch Dippen bzw. Eintauchen elektrisch leitfähiger Klebstoff auf die Anschlußflächen des Bauelements bzw. Chips bzw. ICs aufgebracht wird. Dabei sind Bumps mit einer Mindesthöhe von 50 µm erforderlich, um eine selektive Benetzung zu gewährleisten und eine vollständige Benetzung der gesamten Chipoberfläche beim Dippen zu vermeiden. Nach dem Aufsetzen des Bauelements auf dem Substrat und dem Aushärten des Klebstoffs werden die verbleibenden Fugen mit einem Underfiller aufgefüllt.
- Die Flipchip-Verbindungstechnik mittels eines anisotrop leitfähigen Klebstoffs (ACA; ACA = Anisotrop Conductive Adhesive). Der elektrische Kontakt wird durch vollmetallische oder metallisierte Kügelchen erzielt, die zwischen dem Substrat und dem Bauelement bzw. zwischen den Substratkontakten und den Anschlußflächen des Bauelements eingeklemmt sind.
- Die Flipchip-Verbindungstechnik mittels eines nichtleitfähigen Klebstoffs (NCA; NCA = Non Conductive Adhesive). In diesem Fall wird ein elektrischer Kontakt nicht durch fein verteilte Goldkügelchen in einer Polymermatrix geschaffen, sondern die elektrische Verbindung wird allein über einen Druckkontakt zwischen Anschlußflächen des Bauelements und Substratkontakten geschaffen.

Die beschriebenen, herkömmlichen Aufbau- und Verbindungstechniken weisen eine Reihe von Nachteilen auf. Insbesondere sind die Anschaffungskosten der zur Durchführung der Aufbau- und Verbindungstechniken erforderlichen Bestückungsautomaten sehr hoch. Sie erfordern außerdem einen hohen Programmier-, Einstell- und Einfahraufwand. Bauteile können dabei nur oberhalb einer bestimmten minimalen Bauteilgröße durch die Bestückungsautomaten gehandhabt werden. Gegenwärtig können in der Mikrosystemtechnik nur relativ große Bauteile, deren Größe mindestens im µm-Bereich liegt und deren Komplexität noch gering ist, gehandhabt werden. Da der Betrieb bzw. die Wirkungsweise der Bestückungsautomaten intrinsisch diskontinuierlich und seriell ist, sind einer Beschleunigung bzw. einer Kapazitätserweiterung schwer überwindbare Grenzen gesetzt.

Ein gravierender Nachteil der Flipchip-Verbindungstechniken mittels Klebstoffen ist, daß während des Auspolymerisierens des Klebstoffs ein definierter Druck auf den Montageaufbau bzw. auf Bauelement und Substrat ausgeübt werden muß, um eine sichere Kontaktierung zu erzielen. Um das Bauelement mit mechanischem Druck zu beaufschlagen und gleichzeitig zu heizen, werden sogenannte Thermoden eingesetzt. Selbst bei hohen Aushärtetemperaturen liegen minimal notwendige Härtungszeiten noch im Minutenbereich. Besonders bei quasi kontinuierlich laufenden Bestückungsanlagen beschränkt dieser Prozeßschritt den Durchsatz, was nur mit sehr aufwendigen parallelen Thermodenanordnungen zu kompensieren ist.

Ein weiterer Nachteil des Stands der Technik ist, daß Sensoren und Biosensoren meist nur zur Erfassung einer Größe oder Substanz ausgelegt sind.

WO 98/28320 beschreibt ein Bauelement mit spezifischen DNA-Molekülen und ein Substrat mit dazu komplementären DNA-Molekülen. Das Bauelement wird mit mittels der DNA-Moleküle mit dem Substrat verbunden. Eine Hybridisierung der DNA-Moleküle findet in einer wässrigen Lösung statt. Durch Anlegen eines AC-Feldes werden die Elemente in der wässrigen Lösung bewegt und aneinander angenähert.

Die Aufgabe der vorliegenden Erfindung besteht darin, ein Verfahren zur Herstellung einer Verbundvorrichtung zu zu schaffen, die einen verringerten Herstellungsaufwand aufweisen.

Diese Aufgabe wird durch ein Verfahren gemäß Anspruch 1 gelöst.

Der vorliegenden Erfindung liegt die Idee zugrunde, Bauelemente mit organischen oder anorganischen Molekülen bzw. Makromolekülen zu versehen, beispielsweise mit komplementären DNA-Konfigurationen (Oligonukleotide), Peptiden (Proteinen) oder heterozyklischen Verbindungen bzw. deren Modifikationen. Diese Makromoleküle werden vorzugsweise so ausgewählt, daß sie spezifische bzw. selektive Bindungen eingehen, um vorbestimmte Bauelemente oder vorbestimmte Stellen an Bauelementen miteinander mechanisch zu verbinden. Beispielsweise werden an einem ersten Bauelement ein erster DNA-Einzelstrang und an einem zweiten Bauelement, das mit dem ersten Bauelement verbunden werden soll, ein zweiter, zu dem ersten DNA-Einzelstrang komplementärer DNA-Einzelstrang angebracht. Beide Bauelemente werden in ein Fluid eingebracht, in dem durch Rühren oder Schwenken eine Strömung erzeugt wird, welche die beiden Bauelemente statistisch aneinander annähert. Alternativ werden die Bauelemente durch Vibrationen aneinander angenähert. Bei geeigneter Wahl der Schwingungsfrequenz wird eine stehende Welle bzw. ein Moire-Muster an der Substratoberfläche erzeugt. Bauelemente und/oder Makromoleküle werden dadurch entsprechend der stehenden Welle bzw. dem Moire-Muster lateral strukturiert aufgebracht. Alternativ kann eine Annäherung bzw. eine Ausbildung einer Bindung durch elektrostatische Effekte, ein Konzentrationsgefälle, einen Konzentrationsüberschuß oder auch mit Hilfe von Bakterien oder anderen Kleinstlebewesen, die sich über Duft- oder Botenstoffe orientieren, unterstützt werden.

Wie im Folgenden näher erläutert wird, sind Bauelemente im Sinne der vorliegenden Erfindung beispielsweise elektronische, mikroelektronische, mikromechanische Bauteile oder Systeme, oder auch Moleküle, Makromoleküle oder Cluster von Molekülen.

Wenn die beiden Bauelemente eine vorbestimmte räumliche Beziehung aufweisen, d. h. einen vorbestimmten maximalen Abstand und eine vorbestimmte räumliche Orientierung, zueinander aufweisen, hybridisieren die komplementären DNA-Einzelstränge, d. h. sie bilden einen DNA-Doppelstrang. Dieser DNA-Doppelstrang stellt ein Gesamtmolekül dar, das beide Bauelemente miteinander mechanisch verbindet. Die Stärke der Bindung der DNA-Einzelstränge aneinander ist stark von der Komplementarität der DNA-Einzelstränge abhängig, d. h. die durch die DNA-Einzelstränge vermittelte mechanische Verbindung der beiden Bauelemente ist spezifisch. In dem Fluid können deshalb gleichzeitig mehrere oder sogar viele verschiedene und verschiedenartige Bauelemente vorliegen, die gleichwohl aufgrund der Selektivität des Hybridisierungsvorgangs nur auf eine vorbestimmte Art und Weise bzw. in einer räumlichen Anordnung miteinander verbunden werden, die durch die Anordnung von jeweils paarweise komplementären DNA-Einzelsträngen an den einzelnen Bauelementen bzw. an ausgewählten Stellen an den einzelnen Bauelementen vorbestimmt ist. Die vorliegende Erfindung ermöglicht auf diese Weise eine Selbstorganisation von Bauelementen.

Mit anderen Worten bewirken gemäß der vorliegenden Erfindung vorbestimmte Oberflächenbeschaffenheiten von Bauelementen ein selektives Ankoppeln von modifizierten Makromolekülen auf den Oberflächen der Bauelemente. Beispielweise hybridisiert DNA, die gemäß einem vorgegebenen Muster auf ein Bauelement aufgebracht ist, beim Zusammenfügen mit einem anderen Bauelement oder einem Substrat nur, wenn dieses andere Bauelement oder Substrat das gleiche DNA-Muster mit einer komplementären DNA-Konfiguration aufweist.

Bauelemente im Sinne dieser Erfindung sind dabei neben diskreten oder integrierten elektrischen, elektronischen, mikroelektronischen, mikromechanischen Bauelementen bzw. Bauteilen und Substraten aus Halbleitermaterial, Keramik oder einem anderen Material auch organische und anorganische Schichten, organische und anorganische Partikel sowie organische und anorganische Verbindungen bzw. Moleküle. Sofern es sich bei den Bauelementen im Sinne der vorliegenden Erfindung um Makromoleküle handelt, übernehmen funktionelle Gruppen die Funktion der auf das Bauelement aufgebrachten Moleküle. Durch Modifikation von organischen und anorganischen Makromolekülen werden Schnittstellen für organischanorganische Kopplungen erzeugt und sowohl eine Selbstanordnung bzw. ein "Self-Assembling" als auch eine Modifikation von Oberflächen (Design von Oberflächeneigenschaften) ermöglicht. Organische und anorganische Makromoleküle können durch Anhängen von Haftgruppen oder durch Änderung der Zusammensetzung, der Abfolge bzw. Sequenz, der Seitengruppen etc. modifiziert werden. Beispiele für Haftgruppen, die an Makromoleküle angehängt werden können und eine Verbindung zu einer Oberfläche überhaupt erst ermöglichen bzw. erzielen, sind Thiole und Aminogruppen.

Die Bindungskräfte der Makromoleküle dienen zumindest im Nahbereich bzw. Nahfeld zur Annäherung des einen Bauelements an das andere Bauelement oder an das Substrat. Vorallem aber dienen sie als Klebstoff, um das eine Bauelement an dem anderen Bauelement oder dem Substrat zu fixieren. Vorzugsweise stellen die Makromoleküle ferner einen elektrischen Kontakt her, um beispielsweise eine Leistungsversorgung oder einen Datenaustausch zwischen den Bauelementen zu ermöglichen.

Anstelle der in den obigen Beispielen genannten DNA können andere Makromoleküle, wie z. B. RNA, Peptide, Peptidketten (Oligo-Peptid-Proteine), Fulleren, Thiophen, Polyanilin oder heterozyklische Verbindungen verwendet werden, um mit deren Modifikationen (Thiole, Amine) einen Assemblierungsvorgang zu erzielen.

Die erfindungsgemäße Selbstorganisation ist sowohl bei gro-βen als auch bei mikroskopisch kleinen Bauelementen anwendbar. Die Bauelemente können sowohl elektrische bzw. elektronische bzw. mikroelektronische als auch nichtelektrische, beispielsweise mikromechanische, Bauelemente sein, wobei eine Kopplung bzw. eine mechanische Verbindung zwischen elektrischen und mechanischen Bauelementen ohne Einschränkung möglich ist. Elektrische Bauelemente sind sowohl passive als auch aktive Bauelemente, wie z. B. Widerstände, Kondensatoren, Induktoren bzw. Spulen, Dioden, Transistoren, integrierte Schaltungen, Prozessoren, Photozellen, photoaktive Schichten, elektrisch aktive Schichten und Sensoren. Nichtelektrische Bauelemente sind beispielsweise Passivierungsschichten, funktionale Schichten, Membrane für Sensoren, mechanische Komponenten, optische Bauteile, aber auch chemische Reagenzien, die als Rezeptor oder Signalgeber für einen Sensor dienen. Gemäß der vorliegenden Erfindung können die Bauelemente linear oder in einer oder mehreren Schichten angeordnet und zu einem zwei- oder dreidimensionalen System verbunden werden.

Ein weiterer Aspekt der vorliegenden Erfindung ist die Anwendung in der Mikrosystemtechnik. Partikel, die mit herkömmlichen Manipulatoren nicht mehr zu handhaben sind, werden gemäß der vorliegenden Erfindung mit Hilfe der genannten Makromoleküle an ihren Bestimmungsort transportiert und dort gebunden. Kleine funktionale Nano- oder Piko-Partikel (Cluster von Atomen mit einem minimalen Durchmesser von bis zu 0,5 Å = 50 pm) werden zu einem ein-, zwei- oder dreidimensionalen Gebilde zusammengesetzt, um ein vollständiges Mikrosystem, einen Mikroreaktor, einen Mikro-/Nanocomputer bzw. einen leistungsfähigen Mikro-/Nanoprozessor zu erzeugen. Funktionale Partikel im Sinne der vorliegenden Erfindung sind in fester, flüssiger oder gasförmiger Phase vorliegende Partikel, die durch Anhängen von einem oder mehreren Makromolekülen in ihren physikalischen, chemischen oder mechanischen Eigenschaften nicht oder nur teilweise verändert werden, beispielsweise Fulleren, Thiophen, beschichtete oder unbeschichtete Metallpartikel, optisch aktive und inaktive Substanzen, organische und anorganische Verbindungen. Die funktionalen Partikel oder Makromoleküle können so zu einem beliebigen System organisiert werden.

Ein weiterer Aspekt der vorliegenden Erfindung ist ihre Anwendung in molekularbioelektromechanischen Mikrosystemen, die im Bereich der Medizintechnik eine Kompatibilität von Elektronik und organischem Gewebe, beispielsweise Neuronen und anderen Zellen, ermöglichen oder auch als eigenständige Systeme die Eigenschaften von organischen und anorganischen Materialien vereinen, um beispielsweise Biosensorsysteme zu realisieren.

Die vorliegende Erfindung umfaßt somit wesentliche Verbesserungen gegenüber herkömmlichen Aufbau- und Verbindungstechniken, aber auch gegenüber der herkömmlichen Mikrosystemtechnik und der herkömmlichen Sensortechnik. Verglichen mit herkömmlichen Techniken ist bei der vorliegenden Erfindung die Grenze zwischen mechanischen bzw. mikromechanischen Komponenten einerseits und elektrischen Komponenten andererseits fließend. Gemäß der vorliegenden Erfindung können mikromechanische Bauelemente elektrische Komponenten beinhalten und zu integrierten, dreidimensionalen Systemen aufgebaut werden.

Vorzugsweise wird das erfindungsgemäße Verfahren zur Herstellung der Verbundvorrichtung in einem flüssigen oder gasförmigen Medium durchgeführt. Dieses Fluid enthält alle für den Assemblierungsvorgang notwendigen Substanzen, beispielsweise Puffer, um den pH-Wert des Mediums einzustellen oder zusätzliches elektrisch leitfähiges Kontaktierungsmaterial, wie Fullerene, Polyanilin, beschichtete Metallpartikel oder beschichtete funktionale Polymerpartikel. Die zuletzt genannten zusätzlichen leitfähigen Materialien sind jedoch nicht erforderlich, um einen elektrisch leitfähigen Kontakt zwischen Bauelementen oder einem Bauelement und einem Substrat zu schaffen, wenn die auf den Bauelementen aufgebrachten Moleküle bzw. das aus ihnen gebildete Gesamtmolekül, das die Bauelemente mechanisch miteinander verbindet, gleichzeitig elektrisch leitfähig ist. Dies ist beispielsweise beim DNA-Doppelstrang bzw. der DNA-Helix der Fall. Um jedoch unter bestimmten Voraussetzungen einen spezifischen Leitungseffekt zu erzielen, kann ein elektrisch leitfähiges Material zugegeben werden, oder aber es können die auf die Bauelemente aufgebrachten Moleküle modifiziert sein, um deren elektrische Leitfähigkeit bzw. die elektrische Leitfähigkeit des aus ihnen gebildeten Gesamtmoleküls auf eine erwünschte Weise zu verändern. Dazu können beispielsweise leitende oder halbleitende funktionelle Gruppen an die Moleküle bzw. deren Seitenketten angehängt werden. Als funktionelle Gruppen kommen unter anderem Fullerene (z. B. C₆₀), Polyaniline und Polythiophene in Betracht. Aus den auf diese Weise modifizierten Molekülen werden elektrische Bauelemente bzw. Bauteile erzeugt.

Zum Aufbringen der für den beschriebenen selbstorganisierenden Aufbau erforderlichen Moleküle auf die Bauelemente sind eine bestimmte Beschaffenheit der Oberfläche des Bauelements und bestimmte chemischen Eigenschaften des Moleküls Voraussetzungen. Beispielsweise haftet DNA, die an einem Ende mit einer Aminogruppe modifiziert ist, nur auf einer SiO₂-Oberfläche, DNA, die mit einer Thiol-Gruppe modifiziert ist, haftet nur auf einer Goldoberfläche. Zwei komplementäre DNA-Einzelstränge, die auf zwei Bauelemente aufgebracht sind, hybridisieren zu einem DNA-Doppelstrang, indem sich jeweils paarweise ein Guanin- und ein Cytosin-Rest oder ein Adenin- und ein Thymin-Rest gegenüberstehen und über Wasserstoffbrückenbindungen miteinander verbunden sind.

Die für den beschriebenen selbstorganisierenden Aufbau erforderlichen Moleküle bzw. die funktionalen Materialien werden beispielsweise durch Aufdampfen auf die Bauelemente aufgebracht. Dieses Aufdampfen erfolgt im Vakuum, wie es auch bei CVD- und PVD-Verfahren üblich ist. Alternativ werden die Moleküle mit einem Gasstrom, der beispielsweise ein inertes Trägergas aufweist, in eine Aufdampf-Kammer eingebracht und zu den Bauelementen oder an ihnen vorbei geleitet. Das Aufdampfen erfolgt flächig und unstrukturiert oder aber lateral strukturiert. Zum strukturierten Bedampfen kommen additive oder semiadditive Verfahren zur Anwendung.

Gemäß einem bevorzugten Ausführungsbeispiel werden bekannte technisch herstellbare Makromoleküle, beispielsweise Kohlenstoff C₆₀ oder Peptide, verwendet, deren Oberflächenfunktion gezielt verändert und in einem weiteren Schritt gesteuert wird. Im Fall von C₆₀ erfolgt dies durch Dotieren. Viele verschiedene dotierte und aktivierte Makromoleküle sind kommerziell erhältlich und können relativ einfach auf Oberflächen von Bauelementen organisiert werden. Bei geeigneter elektrischer Kontaktierung üben die Dotieratome einen gezielten Einfluß auf das Oberflächenpotential an bestimmten Stellen des C₆₀-Moleküls aus. Da das Oberflächenpotential direkt mit der chemischen Reaktivität korrespondiert, kann auf diese Weise das chemische Bindungsverhalten beeinflußt werden.

Neben der mechanischen und elektrisch leitfähigen Verbindung der Bauelemente übernehmen die Makromoleküle vorzugsweise weitere Aufgaben und Funktionen. Peptide weisen piezoelektrische Eigenschaften auf, d. h. beim Strecken oder Stauchen von Peptiden treten Ladungsverschiebungen innerhalb der Peptide auf und umgekehrt. Durch Transfer eines Elektrons zu oder von dem Peptid wird eine Längenänderung des Peptids bewirkt und umgekehrt wird durch eine Änderung der Länge des Peptids eine Spannung zwischen dessen Enden erzeugt. Peptide sind deshalb als Sensoren, beispielsweise Drucksensoren, Schalter, in einer elektrisch aktiven Schicht oder auch als funktionale Membran einsetzbar, wobei sie beispielsweise mit einer integrierten Schaltung (IC; IC = integrated circuit), kombiniert werden. Umgekehrt können Peptide als Aktoren bzw. Aktuatoren, Mikro- oder Nanomanipulatoren verwendet werden, indem eine Spannung an die Peptide angelegt wird.

Ein besonderer Vorteil der vorliegenden Erfindung ist die unerschöpfliche Vielzahl von Kombinationsmöglichkeiten von Makromolekülen, um sie als Sensoren, Ladungsverstärker, Aktuatoren, Energiespeicher etc. einzusetzen. Die dreidimensionale Integration von Makromolekülen bzw. Clustern von Makromolekülen im schichtförmigen Aufbau kann hinsichtlich der räumlichen Abfolge der Makromoleküle bzw. der funktionalen Partikel sowohl regelmäßig als auch unregelmäßig sein. Dabei muß eine Schicht nicht nur jeweils eine Sorte von Makromolekülen beinhalten. Die Verbindungen der Makromoleküle untereinander können je nach Bedarf in allen Raumrichtungen ausgerichtet sein und so die Funktionalität der Anordnung erhöhen.

Die erfindungsgemäße hohe Integrationsdichte von Makromolekülen bzw. Clustern von Makromolekülen ermöglicht eine Realisierung von Sensoren zur (gleichzeitigen) Detektion einer Vielzahl von Stoffen. Sensoren, die gemäß der vorliegenden Erfindung aus Makromolekülen aufgebaut sind, ermöglichen eine Reduktion der Größe eines Sensors auf einen Bruchteil der Größe herkömmlicher Sensoren. Daraus resultieren viele Vorteile im Vergleich zur herkömmlichen Sensorik.

Mikromechanische Bauelemente werden herkömmlich in erster Linie nach zwei verschiedenen Verfahren hergestellt. Beim Top-Down-Verfahren wird beispielsweise durch Ätzen, Lasern oder mechanische Bearbeitung Material abgetragen, um ein mikromechanisches Bauteil herzustellen. Das Top-Down-Verfahren eignet sich beispielsweise für ein Piezoventil oder eine piezobetriebene Mikropumpe.

In der Nanotechnologie, auch Bottom-Up-Verfahren genannt, werden nanoskopische Partikel, beispielsweise Kristalle oder Molekülschichten, zu einem makroskopischen System zusammengesetzt.

Ein Vorteil der vorliegenden Erfindung gegenüber beiden herkömmlichen Verfahren zur Herstellung integrierter mikromechanischer Bauelemente ist der Self-Assembly-Aspekt, der ein selbstständiges Zusammenbauen nanoskopischer Partikel und Makromoleküle zu einem nanoskopischen System ermöglicht. Ein weiterer Vorteil ist die hohe erreichbare Integrationsdichte. Im nanoskopischen Bereich kann man um einen Faktor 10³ kleiner entwerfen, arbeiten und herstellen als im mikroskopischen Bereich (1µm = 10³ nm = 10⁶ pm). Ein weiterer Vorteil ist, daß ein Self-Assembly in vielfältigen Arbeitsumgebungen möglich ist, insbesondere in gasförmigen, flüssigen oder gelartigen Medien.

Gemäß einem bevorzugten Ausführungsbeispiel werden die Bauelemente durch Vibrationen aneinander angenähert. Bei Erzeugung einer stehenden Welle bzw. eines Moire-Muster an der Substratoberfläche werden Bauelemente und/oder Makromoleküle entsprechend der stehenden Welle bzw. dem Moire-Muster lateral strukturiert aufgebracht.

Vorzugsweise wird ein Peptid direkt mit einem CMOS-Transistor verbunden, wobei eine Spannung des CMOS-Transistors eine Längenänderung des Peptids oder umgekehrt eine Längenänderung des Peptids eine Spannung an dem CMOS-Transistor hervorruft.

Gemäß einem Ausführungsbeispiel werden ein Fulleren (C₆₀) und eine Peptidkette kombiniert, um einen Nanomanipulator zu erhalten, der als Schnittstelle zu organischer Materie oder als Sensor verwendbar ist. Mittels einer kontrollierbar reversiblen Beeinflussung der Oberflächenfunktion des Fullerens (z. B. durch Dotierung oder Beschichtung) ist eine Realisierung eines "kontrollierten Sticky-End-Manipulators" möglich. Eine Realisierung eines solchen Manipulators bzw. Nanomanipulators sowie ähnlicher "Automaten" hat eine besondere Bedeutung, da sie als Schlüssel zur breiten industriellen Anwendung der Nanosystemtechnologie angesehen wird.

Nachfolgend werden bevorzugte Ausführungsbeispiele der vorliegenden Erfindung mit Bezug auf die beiliegenden Zeichnungen näher erläutert. Es zeigen:
- Fig. 1: eine schematische Darstellung einer Verbundvorrichtung gemäß einem bevorzugten Ausführungsbeispiels der vorliegenden Erfindung;
- Fig. 2: eine schematische Darstellung einer Verbundvorrichtung gemäß einem weiteren bevorzugten Ausführungsbeispiel der vorliegenden Erfindung;
- Fig. 3: eine schematische Darstellung einer Verbundvorrichtung gemäß einem weiteren Ausführungsbeispiel der vorliegenden Erfindung;
- Fig. 4: eine schematische Darstellung einer Verbundvorrichtung gemäß einem weiteren Ausführungsbeispiel der vorliegenden Erfindung;
- Fig. 5: eine schematische Darstellung einer Verbundvorrichtung gemäß einem weiteren Ausführungsbeispiel der vorliegenden Erfindung;
- Fig. 6: eine schematische Darstellung einer Verbundvorrichtung gemäß einem weiteren Ausführungsbeispiel der vorliegenden Erfindung;
- Fig. 7A-7E: schematische Draufsichten eines weiteren Ausführungsbeispieles der vorliegenden Erfindung;
- Fig. 8: eine schematische Darstellung eines weiteren Ausführungsbeispiels der vorliegenden Erfindung; und
- Fig. 9: eine schematische Darstellung eines Gefäßes, in dem ein Verfahren zur Herstellung einer Verbundvorrichtung gemäß einem weiteren Ausführungsbeispiel der vorliegenden Erfindung durchgeführt wird.

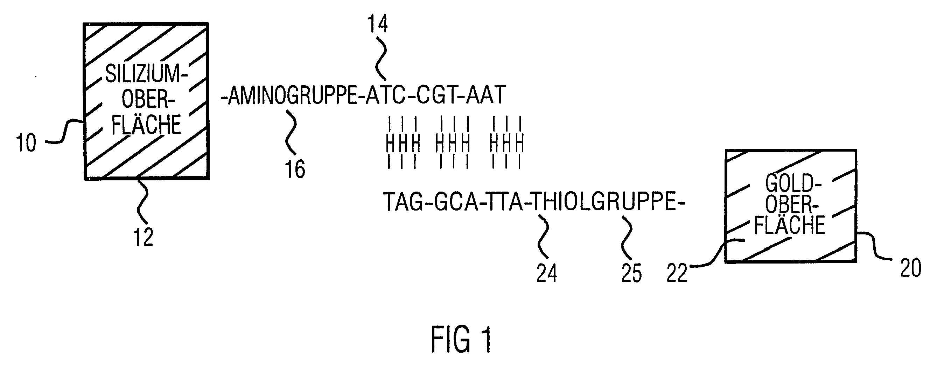

Fig. 1 ist eine schematische mikroskopische Darstellung einer Verbundvorrichtung gemäß einem bevorzugten Ausführungsbeispiel der vorliegenden Erfindung. Ein erstes Bauelement 10 weist eine Siliziumoberfläche 12 auf. An der Siliziumoberfläche 12 ist ein erstes Molekül 14 bzw. eine Aminogruppe 16 des ersten Moleküls 14 angebracht. Das erste Molekül 14 weist ferner eine spezifische Sequenz von vier verschiedenen Basen auf, die einen DNA-Einzelstrang bilden. Die Basen sind Adenin (A), Thymin (T), Cytosin (C) und Guanin (G).

Ein zweites Bauelement 20 weist eine Goldoberfläche 22 auf. An der Goldoberfläche 22 ist ein zweites Molekül 24 bzw. eine Thiolgruppe 25 des zweiten Moleküls 24 angebracht. Das zweite Molekül 24 weist ferner eine spezifische Sequenz der vier genannten Basen Adenen, Thymin, Cytosin und Guanin auf. Die Basensequenz des zweiten Moleküls 24 ist komplementär zu der des ersten Moleküls. Diese Komplementarität besteht darin, daß bei der gezeigten relativen räumlichen Anordnung des ersten Moleküls 14 und des zweiten Moleküls 24 einander immer entweder Adenin und Thymin oder Cytosin und Guanin gegenüberliegen. Nur diese beiden Basenpaare bilden jeweils durch Wasserstoffbrücken bzw. Wasserstoffbrückenbindungen (H) stabile Verbindungen.

In der Darstellung der Fig. 1 sind die beiden komplementären Basensequenzen der Moleküle 14, 24 zu einem DNA-Doppelstrang hybridisiert, d. h. jedes Adenin des einen Moleküls ist mit einem Thymin des anderen Moleküls und jedes Cytosin des einen Moleküls ist mit einem Guanin des anderen Moleküls über eine Wasserstoffbrücke verbunden. Die beiden Moleküle 14, 24 bilden auf diese Weise ein Gesamtmolekül, das einerseits über die Aminogruppe 16 mit dem ersten Bauelement 10 und andererseits über die Thiolgruppe 25 mit dem zweiten Bauelement 20 verbunden ist. Auf diese Weise sind die beiden Bauelemente 10, 20 mechanisch miteinander verbunden.

Die Aminogruppe 16 und die Thiolgruppe 25 sind Beispiele für eine große Anzahl von Haftgruppen, die an DNA-Einzelstränge angehängt werden können, um selektive Bindungen mit verschiedenen Oberflächen von Bauelementen zu schaffen. Die Stärke bzw. die chemische und mechanische Stabilität einer Bindung einer Haftgruppe an einer Oberfläche hängt von der Haftgruppe und der Art der Oberfläche ab. Beispielsweise haftet die in Fig. 1 dargestellte Aminogruppe 16 wesentlich besser an einer Silizium- oder Siliziumdioxid-Oberfläche als an einer Goldoberfläche, während umgekehrt die Thiolgruppe an einer Goldoberfläche wesentlich besser haftet als an einer Silizium- oder Siliziumdioxid-Oberfläche. Durch die Auswahl der Haftgruppe ist deshalb eine Selektivität der Bindung des Moleküls 14, 24 an den Oberflächen 12, 22 erzielbar.

Darüber hinaus kann an jedem Molekül 14, 24 die Basensequenz modifiziert bzw. variiert werden. Da die DNA-Einzelstränge zweier Moleküle 14, 24 nur hybridisieren, wenn ihre Basensequenzen komplementär sind, kann durch die Basensequenzen der Moleküle 14, 24 eine sehr große Selektivität erzeugt werden. So ist es möglich viele verschiedene Bauelemente an verschiedenen Stellen ihrer Oberflächen mit einer großen Zahl verschiedener Moleküle, die DNA-Einzelstränge aufweisen, zu versehen. Durch die Basensequenzen der Moleküle ist dann vorbestimmt, welche Moleküle selektiv miteinander hybridisieren und damit, welche Bauelemente und in welcher relativen räumlichen Anordnung miteinander verbunden werden.

Jedes Moleküle 14, 24 kann somit auf zwei verschiedene Arten modifiziert werden. Einerseits kann die Haftgruppe, die eine Selektivität der Bindung des jeweiligen Moleküls 14, 24 an einer Oberfläche 12, 22 eines Bauelements 10, 20 bestimmt, durch eine andere Haftgruppe ersetzt werden, und andererseits kann die Basensequenz variiert werden, die die Selektivität der Bindung zwischen zwei Molekülen 14, 24 bestimmt.

DNA-Einzelstränge sind nur ein Beispiel für Makromoleküle mit ausgeprägter Selektivität der Bindung. Eine ähnliche Selektivität liegt bei Peptiden, Proteinen oder auch Gen-Antigen-Kombinationen (Schlüssel-Schloß-Prinzip) vor. Darüber hinaus sind beispielsweise Fullerene verwendbar, bei denen Geometrieeffekte und Ladungsdotierungen eine Selektivität bewirken können.

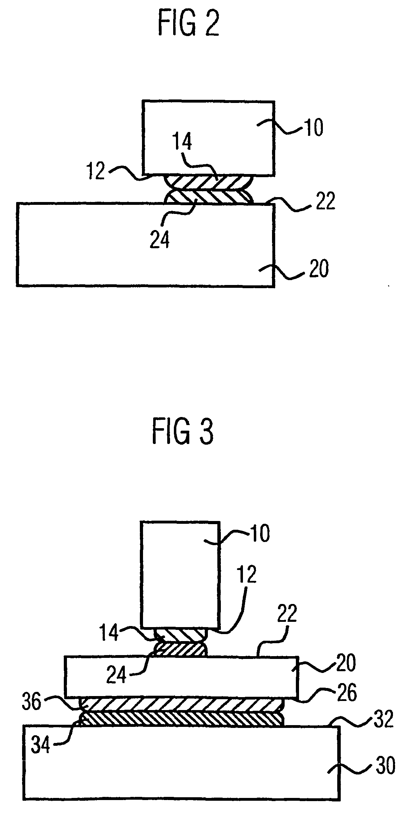

Fig. 2 ist eine schematische Schnittdarstellung einer Verbundvorrichtung gemäß einem Ausführungsbeispiel der vorliegenden Erfindung. Ein erstes Bauelement 10 ist an einer ersten Oberfläche 12 mit ersten Molekülen 14 beschichtet, ein zweites Bauelement 20 ist an einer ersten Oberfläche 22 mit zweiten Molekülen 24 beschichtet. Die ersten Moleküle 14 und die zweiten Moleküle 24 sind so ausgebildet, daß sie miteinander eine oder mehrere Bindungen ausbilden bzw. zu einem Gesamtmolekül reagieren, wenn sie einander begegnen. Die ersten Moleküle 14 und die zweiten Moleküle 24 sind so auf dem ersten Bauelement 10 bzw. dem zweiten Bauelement 20 aufgebracht, daß sie auch nach Ausbildung der Bindung an den ersten Oberflächen 12, 22 des ersten Bauelements 10 bzw. des zweiten Bauelements 20 fest haften. Jedes aus je einem oder mehreren ersten Molekülen 14 und einem oder mehreren zweiten Molekülen 24 gebildete Gesamtmolekül haftet somit gleichzeitig mit seinem von dem ersten Molekül 14 herrührenden Abschnitt an der ersten Oberfläche 12 des ersten Bauelements 10 und mit seinem von dem zweiten Molekül 24 herrührenden Abschnitt an der ersten Oberfläche 22 des zweiten Bauelements 20. Jedes Gesamtmolekül bildet so eine mechanische Verbindung zwischen dem ersten Bauelement 10 und dem zweiten Bauelement 20.

Bei den ersten Molekülen 14 und den zweiten Molekülen 24 handelt es sich vorzugsweise um organische oder anorganische Makromoleküle, insbesondere um DNA-Einzelstränge oder andere Oligonukleotide, Peptide (Proteine) oder heterozyklische Verbindungen bzw. deren Modifikationen. Die ersten Moleküle 14 und die zweiten Moleküle 24 sind ferner vorzugsweise so ausgewählt, daß die Wahrscheinlichkeit einer Reaktion bzw. einer Ausbildung einer Bindung zwischen denselben hoch ist und gleichzeitig das resultierende Gesamtmolekül stabil ist, d. h. eine geringe Zerfallswahrscheinlichkeit aufweist. Gleichzeitig sind die ersten Moleküle 14 und die zweiten Moleküle 24 vorzugsweise so ausgewählt, daß die Wahrscheinlichkeit einer Reaktion bzw. einer Ausbildung einer Bindung zwischen zwei ersten Molekülen 14 oder zwischen zwei zweiten Molekülen 24 gering ist und/oder ein Molekül aus zwei ersten Molekülen 14 oder aus zwei zweiten Molekülen 24 eine geringe Stabilität bzw. eine hohe Zerfallswahrscheinlichkeit aufweist. Auf diese Weise ist gewährleistet, daß das erste Bauelement 10 vor der Ausbildung der in Fig. 2 dargestellten Bindung mit dem zweiten Bauelement 20 keine dauerhafte Bindung mit einem nicht dargestellten weiteren ersten Bauelement ausbildet und desgleichen das zweite Bauelement 20 vor Ausbildung der in Fig. 2 dargestellten Verbindung mit dem ersten Bauelement 10 keine dauerhafte Bindung mit einem weiteren, nicht dargestellten zweiten Bauelement eingeht.

Die ersten Moleküle 14 und die zweiten Moleküle 24 weisen somit im Hinblick auf Reaktionen mit anderen Molekülen selektive Eigenschaften auf, die dazu führen, daß ein erstes Bauelement 10, das nacheinander mit zweiten Bauelementen 20 und weiteren ersten Bauelementen zusammengeführt wird, mit hoher Wahrscheinlichkeit eine Verbundvorrichtung mit einem zweiten Bauelement 20, wie sie in Fig. 2 dargestellt ist, ausbildet und nicht eine Verbindung mit einem weiteren ersten Bauelement.

Die chemischen Eigenschaften und insbesondere die Reaktionswahrscheinlichkeiten der ersten Moleküle 14 und der zweiten Moleküle 20 sind dabei immer von chemischen und physikalischen Eigenschaften ihrer Umgebung abhängig, beispielsweise vom pH-Wert eines Hilfsfluids, das die ersten Moleküle 14 und die zweiten Moleküle 24 bzw. die ersten Bauelemente 10 und die zweiten Bauelemente 20 umgibt, oder auch vom Vorliegen bzw. der Konzentration von Enzymen oder anderen Katalysatoren, von der Temperatur und vom Druck.

Besonders anschauliche Beispiele für die ersten Moleküle 14 und die zweiten Moleküle 24 sind DNA-Einzelstränge, die jeweils bestimmte Sequenzen von Adenin-, Thymin-, Guanin- und Cytosin-Resten aufweisen. Zwei DNA-Einzelstränge sind komplementär und können zu einem DNA-Doppelstrang hybridisieren, wenn sich in den linearen Sequenzen der Aminosäurereste der beiden DNA-Einzelstränge jeweils paarweise ein Guanin- und ein Cytosin-Rest oder ein Adenin- und ein Thymin-Rest gegenüberstehen. Die Wahrscheinlichkeit der Bildung einer mechanischen Verbindung zwischen zwei Bauelementen, auf die jeweils ein DNA-Einzelstrang aufgebracht ist, durch Bildung eines DNA-Doppelstrangs ist somit durch die Aminosäuresequenzen der beiden DNA-Einzelstränge bzw. durch eine vorhandene oder nicht vorhandene Komplementarität derselben vorbestimmt. Da aus den genannten Aminosäureresten eine sehr große Anzahl verschiedener Sequenzen aufgebaut werden kann, wird auch beim Vorliegen vieler verschiedener Bauelemente mittels einer entsprechenden Anzahl verschiedener, paarweise komplementärer DNA-Einzelstränge eine Selektivität erreicht.

Fig. 3 ist eine schematische Schnittdarstellung einer Verbundvorrichtung gemäß einem weiteren Ausführungsbeispiel der vorliegenden Erfindung. Die Verbundvorrichtung des vorliegenden Ausführungsbeispieles unterscheidet sich von der aus Fig. 2 dadurch, daß gegenüber einer zweiten Oberfläche 26 des zweiten Bauelements 20 ein drittes Bauelement 30 angeordnet ist. Auf einer ersten Oberfläche 32 des dritten Bauelements 30 ist ein drittes Molekül 34 aufgebracht, und auf der zweiten Oberfläche 26 des zweiten Bauelements 20 ist ein viertes Molekül 36 aufgebracht. Das dritte Molekül 34 und das vierte Molekül 36 bilden eine Bindung bzw. ein Gesamtmolekül, das das zweite Bauelement 20 und das dritte Bauelement 30 miteinander mechanisch verbindet.

Wiederum sind die ersten, zweiten, dritten und vierten Moleküle 14, 24, 34, 36 vorzugsweise so ausgebildet, daß selektiv die ersten Moleküle 14 und die zweiten Moleküle 24 Bindungen ausbilden sowie die dritten Moleküle 34 und die vierten Moleküle 36 Bindungen ausbilden.

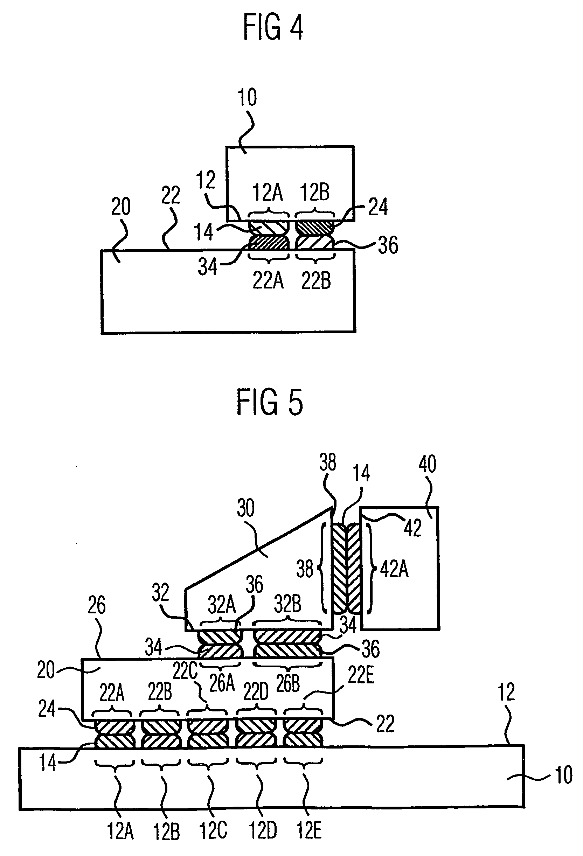

Fig. 4 ist eine schematische Darstellung einer Verbundvorrichtung gemäß einem weiteren Ausführungsbeispiel der vorliegenden Erfindung. Ähnlich wie bei dem in Fig. 2 dargestellten Ausführungsbeispiel weisen das erste Bauelement 10 eine erste Oberfläche 12 und das zweite Bauelement 20 eine erste Oberfläche 22 auf. Abweichend von dem in Fig. 2 dargestellten Ausführungsbeispiel sind an der ersten Oberfläche 12 des ersten Bauelements 10 in einem ersten Abschnitt 12a erste Moleküle 14 und in einem zweiten Abschnitt 12b zweite Moleküle 24 aufgebracht. Auf der ersten Oberfläche 22 des zweiten Bauelements 20 sind in einem ersten Abschnitt 22a dritte Moleküle 34 und in einem zweiten Abschnitt 22b vierte Moleküle 36 aufgebracht.

Die ersten, zweiten, dritten und vierten Moleküle 14, 24, 34, 36 sind so ausgebildet, daß selektiv die ersten Moleküle 14 und die dritten Moleküle 34 Bindungen ausbilden sowie die zweiten Moleküle 24 und die vierten Moleküle 36 Bindungen ausbilden. Selektiv bedeutet in diesem Fall, daß die Wahrscheinlichkeit für die Ausbildung einer Bindung zwischen einem ersten Moleküle 14 und einem vierten Moleküle 36 oder zwischen einem zweiten Moleküle 24 und eine dritten Moleküle 34 geringer ist als für die Ausbildung einer Bindung zwischen einem ersten Moleküle 14 und einem vierten Moleküle 36 oder zwischen einem zweiten Moleküle 24 und einem dritten Moleküle 34 und/oder daß eine Bindung zwischen einem ersten Moleküle 14 und einem dritten Moleküle 34 oder zwischen einem zweiten Moleküle 24 und einem vierten Moleküle 36 stabiler ist bzw. eine geringere Zerfallswahrscheinlichkeit aufweist als eine Bindung zwischen einem ersten Moleküle 14 und einem vierten Moleküle 36 oder zwischen einem zweiten Moleküle 24 und einem dritten Moleküle 34. Diese Selektivität hat zusammen mit der gewählten Anordnung der ersten, zweiten, dritten und vierten Moleküle 14, 24, 34, 36 an den ersten Oberflächen 12, 22 der Bauelemente 10, 20 zur Folge, daß die relative räumliche Orientierung des ersten Bauelements 10 und des zweiten Bauelements 20 eindeutig vorbestimmt ist.

Dieses Ausführungsbeispiel geht damit über das in Fig. 2 dargestellte Ausführungsbeispiel hinaus, bei dem durch die Anordnung der ersten und zweiten Moleküle 14, 24 lediglich festgelegt ist, daß die erste Oberfläche 12 des ersten Bauelements 10 der ersten Oberfläche 22 des zweiten Bauelements 20 gegenüberliegt.

Alternativ zu dem anhand der Fig. 4 dargestellten Ausführungsbeispiel kann eine relative räumliche Orientierung zwischen zwei Bauelementen 10, 20 durch eine anisotrope Anordnung der ersten Moleküle 14 und der zweiten Moleküle 24 auch ohne die dritten Moleküle 34 und die vierten Moleküle 36 vorbestimmt sein. Dazu werden Moleküle ausgewählt, die nur in einer vorbestimmten relativen räumlichen Orientierung eine Bindung ausbilden, und an den Bauelementen 10, 20 mit einer ebenfalls vorbestimmten räumlichen Orientierung angebracht. Dies kann beispielsweise dadurch geschehen, daß längliche Moleküle mit beiden Enden an den Bauelementen befestigt werden oder daß hinreichend starre Moleküle verwendet werden, die mit einer vorbestimmten räumlichen Ausrichtung befestigt werden.

Fig. 5 ist eine Schnittdarstellung einer etwas komplexeren Verbundvorrichtung gemäß einem weiteren Ausführungsbeispiel der vorliegenden Erfindung. Dieses Ausführungsbeispiel umfaßt vier Bauelemente 10, 20, 30, 40. Ein erstes Bauelement 10 weist an einer ersten Oberfläche 12 erste Moleküle 14 und zweite Moleküle 24 auf, wobei die ersten Moleküle 14 und die zweiten Moleküle 24 abwechselnd in nebeneinanderliegenden Abschnitten 12a, 12b, 12c, 12d, 12e auf die erste Oberfläche 12 aufgebracht sind.

Ein zweites Bauelement 20 weist an einer ersten Oberfläche 22 ebenfalls erste Moleküle 14 und zweite Moleküle 24 auf. Die ersten Moleküle 14 und die zweiten Moleküle 24 sind abwechselnd in Abschnitten 22a, 22b, 22c, 22d, 22e auf die erste Oberfläche 22 des zweiten Bauelements 20 aufgebracht. Anordnung, Größe und Form der Abschnitte 22a - 22e an der ersten Oberfläche 22 des zweiten Bauelements 20 entsprechen spiegelbildlich Anordnung, Größe und Form der Abschnitte 12a - 12e an der ersten Oberfläche 12 des ersten Bauelements 10, wobei jeweils in einem Abschnitt 12a - 12e am ersten Bauelement erste Moleküle 14 und in dem entsprechenden Abschnitt 22a - 22e am zweiten Bauelement 20 zweite Moleküle 24 aufgebracht sind oder umgekehrt.

Bei einer entsprechenden relativen räumlichen Orientierung des ersten Bauelements 10 und des zweiten Bauelements 20 liegen somit immer Abschnitte 12a - 12e, 22a - 22e mit ersten Molekülen 14 bzw. zweiten Molekülen 24 einander gegenüber. Wenn das zweite Bauelement 20 sich dem ersten Bauelement 10 in dieser räumlichen Orientierung nähert, bilden sich, wie bei den vorausgegangenen Ausführungsbeispielen, Bindungen zwischen ersten Molekülen 14 und zweiten Molekülen 24 aus, die zu einer mechanischen Verbindung des ersten Bauelements 10 mit dem zweiten Bauelement 20 führen.

Während bei der dargestellten relativen Anordnung des ersten Bauelements 10 und des zweiten Bauelements 20 alle ersten Moleküle 14 und alle zweiten Moleküle 24 zu der mechanischen Verbindung zwischen den beiden Bauelementen beitragen, tragen bei einer lateral gegenüber diesem Zustand versetzten Annäherung der beiden Bauelemente oder im Falle zweier erster Bauelemente 10 oder zweier zweiter Bauelemente 20 nicht alle ersten Moleküle 14 und alle zweiten Moleküle 24 zur mechanischen Verbindung der Bauelemente bei. Eine solche mechanische Verbindung ist deshalb schwächer und wird leichter wieder gelöst als die in Fig. 5 dargestellte. Bei diesem Ausführungsbeispiel trägt somit nicht nur die Auswahl der ersten Moleküle 14 und der zweiten Moleküle 24, sondern ähnliche wie in dem Ausführungsbeispiel aus Fig. 3 auch deren räumliche Anordnung an den entsprechenden Bauelementen zu einer Selektivität bei.

Auf einer zweiten Oberfläche 26 des zweiten Bauelements 20 sind in einem ersten Abschnitt 26a dritte Moleküle 34 und in einem zweiten Abschnitt 26b vierte Moleküle 36 aufgebracht. Dieser Anordnung spiegelbildlich entsprechend sind auf eine erste Oberfläche 32 des dritten Bauelements 30 in einem ersten Abschnitt 32a vierte Moleküle 36 und in einem zweiten Abschnitt 32b dritte Moleküle 34 aufgebracht. Bei der dargestellten relativen räumlichen Anordnung und Orientierung des zweiten Bauelements 20 und des dritten Bauelements 30 bilden alle dritte Moleküle 34 mit vierten Molekülen 36 Bindungen aus, welche eine mechanische Verbindung des zweiten Bauelements 20 mit dem dritten Bauelement 30 bewirken. Eine Selektivität bezüglich der gebundenen Bauelemente sowie deren räumlicher Anordnung und Orientierung wird wiederum sowohl durch die Auswahl der dritten und vierten Moleküle 34, 36 als auch durch Anordnung, Größe und Form der Abschnitte 26a, 26b, 32a, 32b bewirkt.

Das dritte Bauelement 30 weist an einer zweiten Oberfläche 38 in einem Abschnitt 38a erste Moleküle 14 auf. das vierte Bauelement 40 weist in einem Abschnitt 42a auf einer Oberfläche 42 zweite Moleküle 24 auf, wobei vorzugsweise Größe und Form des Abschnitts 42a auf der Oberfläche 42 des vierten Bauelements 40 und Größe und Form des Abschnitts 38a der zweiten Oberfläche 38 des dritten Bauelements 30 einander spiegelbildlich entsprechen. Eine Selektivität hinsichtlich der verbundenen Bauelemente, ihrer räumlichen Anordnung und Orientierung wird durch die Auswahl der ersten und zweiten Moleküle 14, 24 sowie durch Größe und Form der Abschnitte 38a, 42a gewährleistet. Die ersten, zweiten, dritten und vierten Moleküle 14, 24, 34, 36 sind vorzugsweise so ausgewählt, daß nur erste Moleküle 14 mit zweiten Molekülen 24 oder dritte Moleküle 34 mit vierten Molekülen 36 stabile Bindungen ausbilden und alle anderen möglichen Molekülpaare wesentlich geringere Reaktionswahrscheinlichkeiten oder wesentlich höhere Zerfallswahrscheinlichkeiten ihrer Bindungen aufweisen. Ferner sind die Abschnitte 12a - 12e, 22a - 22e, 38a, 42a hinsichtlich ihrer Größe und ihrer Form so ausgebildet, daß unerwünschte mechanische Verbindungen zwischen Bauelementen 10, 20, 30, 40 nur mit geringer Wahrscheinlichkeit auftreten und/oder eine geringe Stabilität aufweisen bzw. schnell wieder zerfallen.

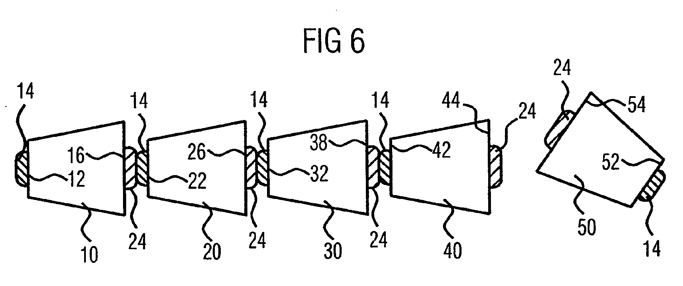

Fig. 6 ist eine schematische Schnittdarstellung einer Kette bzw. eines Drahts aus einer Mehrzahl gleicher Bauelemente 10, 20, 30, 40. Jedes der Bauelemente 10, 20, 30, 40 weist an einer ersten Oberfläche 12, 22, 32, 42 erste Moleküle 14 und an einer der ersten Oberfläche 12, 22, 32, 42 gegenüberliegenden zweiten Oberfläche 16, 26, 38, 44 zweite Moleküle 24 auf. Zwischen ersten Molekülen 14 an einem Bauelement 20, 30, 40 und zweiten Molekülen 24 an einem anderen Bauelement 10, 20, 30 bilden sich Bindungen aus, so daß die Bauelemente 10, 20, 30, 40 jeweils durch aus den ersten Molekülen 14 und den zweiten Molekülen 24 gebildete Gesamtmoleküle mechanisch miteinander verbunden sind. Vorzugsweise sind die ersten Moleküle 14 und die zweiten Moleküle 24 hinsichtlich ihres chemischen Verhaltens bzw. die durch die ersten Moleküle 14 und die zweiten Moleküle 24 ausgebildeten Bindungen ähnlich selektiv wie in den anhand der Fig. 2 bis 5 dargestellten Ausführungsbeispiele. Es resultiert der in Fig. 6 dargestellte Draht aus einer Mehrzahl von gleichen Bauelementen 10, 20, 30, 40.

Neben dem bereits aus den Bauelementen 10, 20, 30 und 40 gebildeten Draht ist in Fig. 6 ein weiteres Bauelement 50 dargestellt, das sich bereits in der Nähe des durch das Bauelement 40 gebildeten Endes des Drahts aufhält. Dieses Bauelement 50 weist einen zu den Bauelementen 10, 20, 30, 40 identischen Aufbau und insbesondere wie diese erste Moleküle 14 auf einer ersten Oberfläche 52 und zweite Moleküle 24 auf einer zweiten Oberfläche 54 auf. Bei der vorliegenden Orientierung des Bauelements 50 relativ zu dem Bauelement 40 kann das Bauelement 50 auch bei einer stärkeren Annäherung an das Bauelement 40 noch nicht an dieses gebunden werden, da die ersten Moleküle 14 des Bauelements 50 und die zweiten Moleküle 24 des Bauelements 40 einander noch nicht gegenüberliegen.

Wenn das Bauelement 40 sich um ca. 45° gegen den Uhrzeigersinn dreht, liegen die zweiten Moleküle 24 des Bauelements 50 und die zweiten Moleküle 24 des Bauelements 40 einander gegenüber. Die oben beschriebene Selektivität bedeutet, daß in diesem Fall auch bei einer stärkeren Annäherung des Bauelements 50 an das Bauelement 40 keine oder keine dauerhafte Bindung zwischen den zweiten Molekülen 24 des Bauelements 50 und den zweiten Molekülen 24 des Bauelements 40 ausgebildet wird. Wenn jedoch das Bauelement 50 sich um ca. 135° im Uhrzeigersinn dreht, liegen die ersten Moleküle 14 des Bauelements 50 den zweiten Molekülen 24 des Bauelements 40 gegenüber, und bei einer weiteren Annäherung des Bauelements 50 an das Bauelement 40 kommt es mit einer großen Wahrscheinlichkeit zur Ausbildung einer stabilen Bindung zwischen den ersten Molekülen 14 des Bauelements 50 und den zweiten Molekülen 24 des Bauelements 40. Das Bauelement 50 ist dann durch die resultierenden Gesamtmoleküle mechanisch mit dem Bauelement 40 verbunden und der Draht bzw. die Kette ist um ein Bauelement verlängert.

Alternativ sind die Bauelemente 10, 20, 30, 40, 50 nicht gleich sondern verschieden, wobei die Reihenfolge der Bauelemente 10, 20, 30, 40 vorzugsweise wiederum wie in den Ausführungsbeispielen der Fig. 3 und 5 durch die Auswahl mehrerer verschiedener Molekülpaare anstelle des einen Molekülpaares 14, 24 vorbestimmt ist.

Die in Fig. 6 dargestellten Bauelemente 10, 20, 30, 40, 50 sind beispielsweise elektronische, mikromechanische oder andere Bauelemente aus Halbleitermaterial. Alternativ sind die dargestellten Bauelemente selbst Makromoleküle, beispielsweise Peptide (Proteine), Fullerene (C60 u. a.), halbleitende Makromoleküle (Pentacen, Kupfer-2-Phthalocyanin, andere Phthalocyanine, Poly-3-Hexylthiophen-2,5-Diyl, andere Hexylthiophene etc.). In diesem Fall sind die die Makromoleküle verbindenden Moleküle 14, 24 vorzugsweise DNA-Einzelstränge, die an die Makromoleküle gebunden sind. Einige Makromoleküle sind elektrisch leitfähig. Andere sind nicht oder nicht ausreichend elektrisch leitfähig und müssen deshalb mit gut leitfähigen Makromolekülen gepaart werden, um eine längere Kette bzw. einen längeren Draht der schlecht leitfähigen Makromoleküle mit einer für eine bestimmte Anwendung ausreichenden elektrischen Leitfähigkeit zu bilden. Der DNA-Doppelstrang weist eine gute elektrische Leitfähigkeit auf und kann als Verbindungselement für schlecht leitfähige oder auch für funktionale Makromoleküle verwendet werden.

Bei den oben anhand der Fig. 2 bis 6 dargestellten Ausführungsbeispiele sind jeweils eine Mehrzahl von ersten Molekülen 14 und zweiten Molekülen 24 bzw. dritten Molekülen 34 und vierten Molekülen 36 gegenüberliegend angeordnet und bilden paarweise Bindungen aus. Anders ausgedrückt wird eine Mehrzahl von Gesamtmolekülen gebildet. Besonders im Fall sehr kleiner Bauelemente 10, 20, 30, 40 kann aber statt einer Mehrzahl von Molekülen auch jeweils nur ein Molekül verwendet werden. In den Fig. 2 bis 6 sind die Moleküle 14, 24, 34, 36 zugunsten einer klareren Darstellung getrennt dargestellt. Tatsächlich haben sie in den dargestellten Zuständen bereits Bindungen miteinander ausgebildet bzw. Gesamtmoleküle gebildet und können somit je nach Art der Moleküle und ihrer Bindung unter Umständen nicht mehr eindeutig voneinander unterschieden bzw. getrennt werden. Die Bindungen zwischen den ersten Molekülen 14 und den zweiten Molekülen 24 bzw. zwischen den dritten Molekülen 34 und den vierten Molekülen 36 können Wasserstoffbrückenbindungen, Van-der-Waals-Bindungen, ionische Bindungen, kovalente Bindungen etc. sein. Bindungen können spontan, katalytisch bzw. enzymatisch unterstützt, exotherm oder auch endotherm ausgebildet werden, wobei Wasser oder eines oder mehrere andere Moleküle abgespalten werden können.

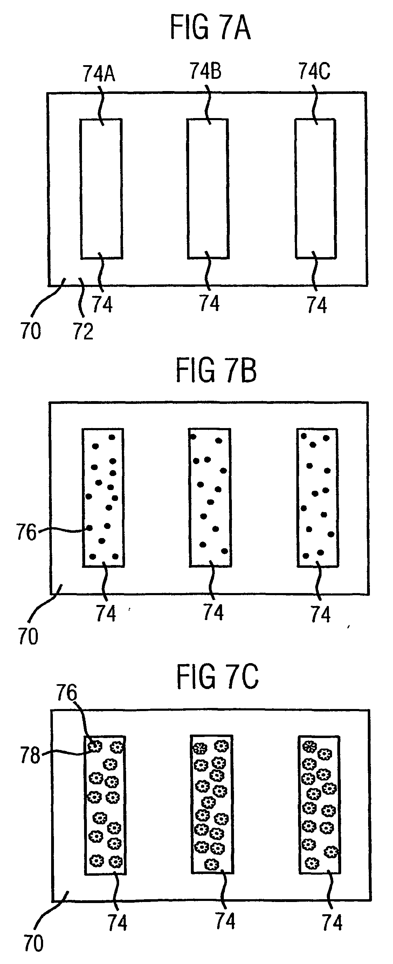

Fig. 7A-7E sind schematische Darstellungen eines weiteren Ausführungsbeispieles der vorliegenden Erfindung. Fig 7A zeigt eine schematische Draufsicht eines Substrats 70, an dessen Oberfläche 72 lithographisch, elektrostatisch, durch Siebdruck, Tiefdruck, Laserdruck, Aufsetzdruck etc. eine Struktur 74 erzeugt wurde. Die Struktur 74 besteht in diesem Beispiel aus Rechtecken 74a, 74b, 74c, innerhalb derer die Oberfläche 72 des Substrats 70 mit Gold beschichtet ist.

Fig 7B ist eine schematische Darstellung des Substrats 70 nach einem weiteren Verfahrensschritt, bei dem DNA-Einzelstränge 76, die mit je einer Thiolgruppe als Haftgruppe versehen sind, auf das Substrat 70 aufgebracht wurden. Die Thiolgruppen haften nur auf den mit Gold beschichteten Rechtecken 74a, 74b, 74c, nicht jedoch auf den anderen Abschnitten der Oberfläche 72 des Substrats 70. Die Anordnung der DNA-Einzelstränge 76 auf der Oberfläche 72 ist deshalb durch die Struktur 74 vorbestimmt.

In einem weiteren Verfahrensschritt werden die DNA-Einzelstränge 76 mit komplementären DNA-Einzelsträngen 78, die mit Makromolekülen oder Partikeln modifiziert sind, hybridisiert. Damit ist eine erste Schicht fertiggestellt, und es resultiert der in Fig. 7C dargestellte Zustand.

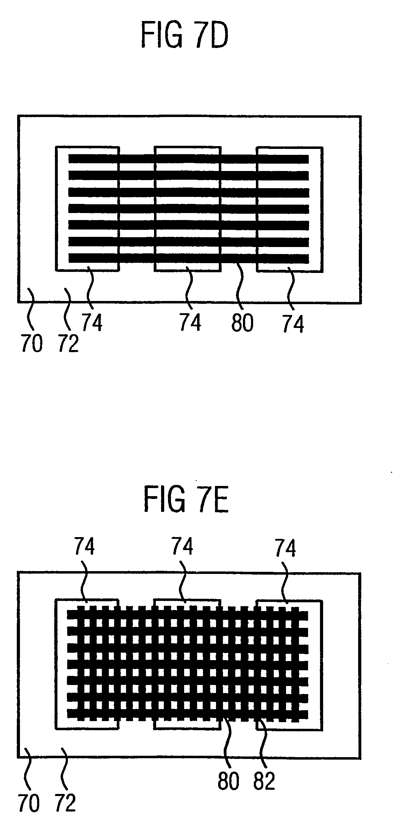

Im Sinne einer klaren Darstellung sind ab der Fig. 7D die DNA-Einzelstränge 76, 78 nicht mehr dargestellt.

In einem weiteren Verfahrensschritt wird eine neue Schicht erzeugt, die eine sehr viel kleinere Struktur besitzt, indem man die funktionalen Makromoleküle bzw. Partikel miteinander vernetzt und einen sogenannten Draht über die erste Schicht legt, um den in Fig. 7D dargestellten Zustand zu erhalten.

Über dieser zweiten Struktur kann in einem weiteren Verfahrensschritt wiederum DNA mit Haftgruppen angelagert werden, um die in Fig. 7E dargestellte Struktur zu erhalten.

Die in den Figuren 7A-7E dargestellte Anordnung ist ein Beispiel für ein molekularbioelektromechanisches Mikrosystem. Unter Verwendung von Makromolekülen wie Peptiden, Fullerenen und DNA, die in einer geeigneten Abfolge aneinandergereiht bzw. miteinander vernetzt sind, können beispielsweise optisch-elektrische Wandler, Aktuatoren, massenabhängige (adsorptive) Aktuatoren oder adsorptive Sensoren hergestellt werden.

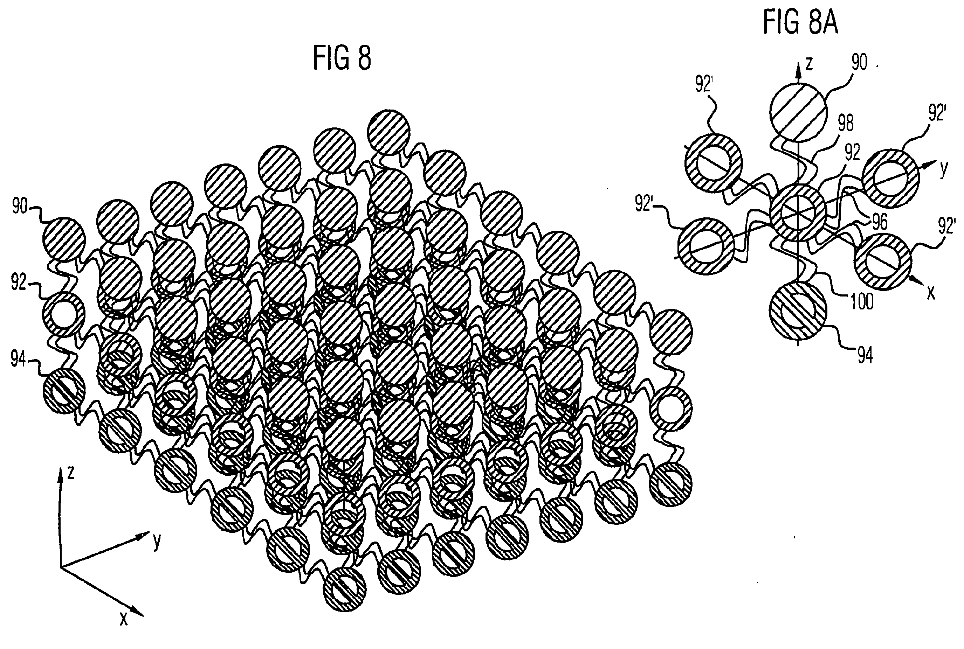

Fig. 8 ist eine schematische Darstellung eines Beispiels für ein solches molekularbioelektromechanisches Mikrosystem. In einer obersten Schicht sind Lumineszenzpartikel 90 angeordnet, die die Eigenschaft aufweisen, bei Einfall von Licht Elektronen abzugeben. In einer darunterliegenden Ebene sind Peptid-Moleküle 92 angeordnet, die als Ladungsverstärker oder, ähnlich einem Piezo oder einer beweglichen Membran, als Aktuator vorgesehen sind. In einer weiteren Ebene darunter sind Fulleren-Moleküle 94 angeordnet. Ein Fulleren speichert Ladungsträger in Form einer Ladungsdotierung, die die elektrische Leitfähigkeit des Fullerens verändert. In der dargestellten Anordnung funktionieren die Fulleren-Moleküle 94 wie ein Diodenarray. Innerhalb der Schichten, d.h. in x- und y-Richtung und zwischen den Schichten, d.h. in z-Richtung existieren elektrische leitfähige Verbindungen zwischen den Molekülen, die beispielsweise durch Nanotubes, DNA mit funktionalen Makromolekülen beschichtete DNA-Nanowires etc. gebildet werden. Fig. 8A ist eine vergrößerte Darstellung eines Ausschnitts des molekularbioelektromechanischen Mikrosystems. In dieser Darstellung ist gut zu erkennen, daß jedes Peptid-Molekül 92 elektrisch leitfähige Verbindungen 96 zu in x- oder y-benachbarten Peptid-Molekülen 92' aufweist. Darüber hinaus weist das Peptid-Molekül 92 eine elektrisch leitfähige Verbindung 98 zu den in z-Richtung benachbarten Lumineszenzpartikel 90 und eine elektrisch leitfähige Verbindung 100 zu dem in z-Richtung benachbarten Fulleren 94 auf.

Durch Lichteinfall in dem in Fig. 8 dargestellten molekularbioelektromechanischen Mikrosystem erzeugte Signale können wie bei einem Diodenarray ausgewertet werden. Ebenfalls wie bei einem Diodenarray können die einzelnen Matrixschichten der dreidimensionalen Anordnung mit Energie versorgt werden. Ein wichtiger Vorteil der erfindungsgemäßen molekularbioelektromechanischen Mikrosysteme ist die Integration mehrerer Sensoren-, Aktoren- oder Halbleiter-Cluster in einer Schicht oder sogar in einem dreidimensionalen Aufbau.

Das anhand der Fig. 8 dargestellte Mikrosystem kann durch zusätzliche Schichten, Querverbindungen, funktionale Partikel, Makromoleküle, Nanotubes usw. in seiner Komplexität und Funktionalität beliebig erweitert werden.

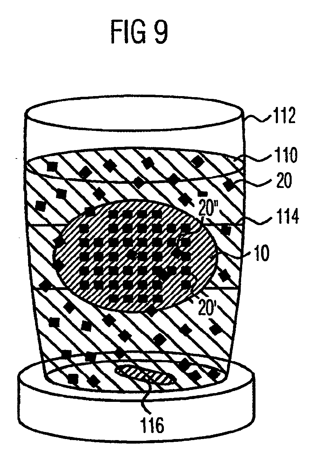

Im Folgenden wird mit Bezug auf Fig. 9 ein Verfahren zur Annäherung zweier Bauelemente aneinander beschrieben.

Fig. 9 ist eine schematische Darstellung eines Hilfsfluids 110 in einem Gefäß 112, in dem eine Verbundvorrichtung gemäß der vorliegenden Erfindung hergestellt wird. In dem Hilfsfluid 110 befindet sich ein erstes Bauelement 10, das hier ein Substrat ist, beispielsweise ein Halbleiterwafer, ein Chip oder ein anderes Halbleitersubstrat, ein keramisches Substrat oder eine Leiterplatte. Das Substrat 10 wird durch Halterungen 114 so in dem Hilfsfluid 110 gehalten, daß zumindest die Oberfläche oder die Oberflächen, die bestückt werden sollen, ungehindert von dem Hilfsfluid umspült werden. In dem Hilfsfluid befinden sich eine Mehrzahl von zweiten Bauelementen 20 sowie ein Rührfisch 116. Das Hilfsfluid 110 enthält ferner Hilfssubstanzen, wie z. B. einen pH-Puffer zur Einstellung des pH-Werts. Eine Heizplatte 118 ist dafür vorgesehen, eine erwünschte Temperatur des Hilfsfluids 110 zu erzeugen. In oder unter der Heizplatte 118 ist eine nicht dargestellte magnetische Vorrichtung zum Bewegen des ebenfalls magnetischen Rührfischs 116 vorgesehen.

Auf Abschnitten des Substrats 10, an denen zweite Bauelemente 20 angebracht werden sollen, wurden vor dem Einbringen des Substrats 10 in das Hilfsfluid 110 wie in den vorangegangenen Ausführungsbeispielen erste Moleküle aufgebracht, die hier nicht dargestellt sind. Desgleichen wurden auf die zweiten Bauelemente 20 vor dem Einbringen derselben in das Hilfsfluid 110 ebenfalls nicht dargestellte zweite Moleküle aufgebracht, wobei die ersten und zweiten Moleküle dafür vorgesehen sind, durch Ausbildung einer Bindung bzw. Reaktion zu einem Gesamtmolekül eine mechanische Verbindung zwischen dem Substrat 10 und dem jeweiligen zweiten Bauelement 20 herzustellen.

Wenn die Anordnung der Bauelemente 20 auf dem Substrat 10 beliebige ist, beispielsweise da keine elektrischen Kontakte hergestellt werden müssen oder die elektrischen Kontakte symmetrisch oder redundant auf der Oberfläche des Substrats 10 verteilt sind, kann die Oberfläche des Substrats 10 ganzflächig mit Oligonukleotiden beschichtet werden. Soll eine bestimmte Anordnung der Bauelemente 20 auf dem Substrat 10 erreicht werden, so können die Moleküle in einem entsprechenden, vordefinierten Muster aufgebracht werden.

Sowohl das Aufbringen der ersten Moleküle auf das Substrat als auch das Aufbringen der zweiten Moleküle auf die zweiten Moleküle erfolgen beispielsweise durch Aufdampfen. Ähnlich wie bei CVD- und PVD-Verfahren werden die Moleküle in Vakuum aufgedampft. Alternativ werden sie mittels eines Gasstroms in eine Kammer, in der die zu bedampfenden Bauelemente angeordnet sind, eingebracht und zu den Bauelementen oder an ihnen vorbei geleitet. Dieser Gasstrom enthält neben den Molekülen ein oder mehrere weitere Komponenten, beispielsweise ein inertes Trägergas. Die Moleküle können sowohl lateral strukturiert als auch unstrukturiert bzw. vollflächig aufgebracht werden. Zur strukturierten Aufbringung kommen sowohl additive als auch semiadditive Verfahren in Frage.

Durch Bewegen des Rührfisches 116 in dem Hilfsfluid 110 wird dieses in Bewegung versetzt, wobei die zweiten Bauelemente 20 statistisch zu dem Substrat 10 bzw. an dem Substrat 10 vorbei bewegt werden. Jedesmal, wenn ein zweites Bauelement 20 dem Substrat 10 an einer Stelle, auf die eines oder mehrere erste Moleküle aufgebracht sind, und mit der richtigen räumlichen Orientierung nahe genug kommt, können das oder die ersten Moleküle auf dem Substrat 10 und das oder die zweiten Moleküle an dem zweiten Bauelement 20 eine Bindung ausbilden bzw. eine chemische Reaktion durchlaufen, um eines bzw. mehrere Gesamtmoleküle zu bilden, das bzw. die eine mechanische Verbindung zwischen dem Substrat 10 und dem zweiten Bauelement 20 herstellen. Auf diese Weise werden nach und nach alle dafür vorgesehenen Abschnitte des Substrats 10 mit zweiten Bauelementen 20 bestückt.

Zweite Bauelemente 20, deren genaue Anordnung oder räumliche Orientierung auf dem Substrat 10 nicht ganz der erwünschten und durch die ersten Moleküle vorgegebenen entspricht, weisen aufgrund der Selektivität von Auswahl und Anordnung der ersten und zweiten Moleküle eine weniger stabile mechanische Verbindung zu dem Substrat 10 auf. Diese Bindungen werden beispielsweise aufgrund der Temperatur des Hilfsfluids 110 oder der in ihm herrschenden Strömung wieder gelöst, so daß im wesentlichen nur zweite Bauelemente 20 auf dem Substrat 10 verbleiben, deren Anordnung und Orientierung der erwünschten Anordnung und der erwünschten Orientierung entsprechen. In Fig. 9 ist das zweite Bauelement 20' ein Beispiel für ein korrekt mit dem Substrat 10 verbundenes Bauelement, während das Bauelement 20" ein Beispiel für ein Bauelement ist, das sich dem Substrat 10 gerade nähert oder falsch an ihm befestigt ist.

Alternativ zur Vorgabe der lateralen Struktur, der entsprechend die zweiten Moleküle auf das Substrat aufzubringen sind, durch eine entsprechende laterale Struktur wird diese durch im Fluid erzeugte stehende Wellen oder Moire-Muster an dem Substrat definiert. Dabei ist keine lateral strukturierte Anordnung der ersten Moleküle an dem Substrat erforderlich. Durch eine oder mehrere Schwingungsquellen und ggf. mittels Reflektoren oder eines Resonators wird die stehende Welle bzw. das Moire-Muster an dem Substrat erzeugt. Dadurch liegen an dem Substrat Orte mit großer Druckamplitude und verschwindender Geschwindigkeitsamplitude ("Bäuche") und Orte mit verschwindender Druckamplitude und großer Geschwindigkeitsamplitude ("Knoten") vor.

Der Einfluß der stehenden Welle auf das Bindungsverhalten bzw. die Anlagerung der Moleküle ist abhängig von den Molekülen, von der Substratoberfläche, von den Eigenschaften der Bindungen zwischen den Molekülen und der Oberfläche des Substrats, von dem Hilfsfluid, von der Amplitude und der zeitlichen und räumlichen Frequenz der stehenden Welle, von der Konzentration der Bauelemente im Hilfsfluid, von der Dauer der Einwirkung etc. Die zweiten Bauelemente lagern sich nur oder bevorzugt entweder an den Orten verschwindender Geschwindigkeitsamplitude oder an den Orten verschwindender Druckamplitude ab. In beiden Fällen wird eine (positive oder negative) laterale Struktur der zweiten Bauelemente an dem Substrat erzeugt, die durch eine lateral strukturierte Anordnung der ersten Moleküle an dem Substrat modifiziert sein kann.

Ferner können auch die ersten Moleküle mittels stehender Wellen oder eines Moire-Musters lateral strukturiert auf das Substrat aufgebracht werden.

Der eigentliche Assemblierungsvorgang des Substrats 10 und der zweiten Bauelemente 20 erfolgt somit ohne daß jedes zweite Bauelement 20 einzeln gegriffen, bewegt, positioniert und befestigt werden muß. Vielmehr kann eine nahezu beliebig große Anzahl von zweiten Bauelementen 20 gleichzeitig auf das Substrat 10 aufgebracht werden. Die für eine herkömmliche Handhabung der Bauelemente erforderliche Mindestgröße derselben entfällt dabei, da auch beliebig kleine Bauelemente in dem Hilfsfluid und durch das Hilfsfluid 110 bewegt werden. Die vorliegende Erfindung ermöglicht somit nicht nur ein besonders kostengünstiges Assemblieren, sondern auch ein Assemblieren von Bauelementen mit einem Miniaturisierungsgrad, der eine herkömmliche Assemblierung unmöglich oder unwirtschaftlich macht.

Die vorliegende Erfindung eignet sich damit sowohl für extrem leistungsfähige Elektronik mit einer sehr hohen Integrationsdichte als auch für eine besonders kostengünstige Herstellung von Massenprodukten im Low-Cost-Bereich. Weitere Anwendungsfelder erschließen sich dadurch, daß die vorliegende Erfindung eine vollständige Systemintegration ermöglicht, die sowohl elektrische und elektronische als auch biochemische und mechanische Komponenten umfaßt. Ferner ist sowohl ein Abscheiden von einzelnen Schichten von zweiten Bauelementen 20 auf Oberflächen als auch ein Aufbau von dreidimensionalen Systemen möglich.

Das Hilfsfluid 110 kann dabei nicht nur eine Art von Bauelementen enthalten, sondern nahezu beliebig viele, die mit Molekülen einer geeigneten Selektivität versehen sind, so daß jedes Bauelement "seine" Stelle auf dem Substrat 10 findet. Vorzugsweise weist jedes Bauelement eines oder mehrere Moleküle auf, die das Bauelement, beispielsweise mittels einer spezifischen Aminosäuresequenz, eindeutig identifizieren. Dazu wird auf das Substrat an jeder Stelle, an der ein bestimmtes Bauelement vorgesehen ist, eine zu der Aminosäuresequenz des Bauelements komplementäre Aminosäuresequenz aufgebracht. Anschließend wird das Substrat zusammen mit allen Bauelementen in das Hilfsfluid 110 eingebracht, in dem das Substrat 10 durch Selbstorganisation statistisch, aber dem vorbestimmten Bestimmungsplan entsprechend, bestückt wird.

Zur Erzeugung geeigneter Strömungsverhältnisse können anstatt eines Rührfischs auch andere herkömmliche Rührer verwendet werden, Gase eingeleitet werden, Vibrationen bzw. Schwingungen erzeugt werden, durch lokales Erwärmen und/oder Kühlen des Hilfsfluids 110 konvektive Strömungen erzeugt werden, wobei Heizleistung beispielsweise mittels elektromagnetischer Strahlung appliziert werden kann.

Die mechanische Verbindung der Bauteile mit dem Substrat bzw. der Substratoberfläche wird durch die Bindungskräfte zwischen den DNA-Ketten maßgeblich unterstützt. Ferner können Kapillarkräfte die Haftung der Bauelemente an dem Substrat positiv beeinflussen. Nach erfolgter Bestückung des Substrats mit den Bauelementen wird dieses aus dem Hilfsfluid herausgenommen und getrocknet. Die bestehenden mechanischen Verbindungen zwischen dem Substrat und den Bauelementen können bestehen bleiben und während der Lebensdauer des bestückten Substrats die einzigen bleiben. Alternativ können die Bauelemente anschließend beispielsweise mittels eines Klebstoffs oder mittels Lötungen zusätzlich mit dem Substrat verbunden werden. Bei einem Lötvorgang werden Makromoleküle abhängig von ihrer thermischen Stabilität zerstört. Während durch Lötungen gleichzeitig elektrisch leitfähige Verbindungen zwischen dem Substrat und den Bauelementen geschaffen werden können, können solche elektrisch leitfähige Verbindungen jedoch auch ausschließlich durch die bei der Bestückung gebildeten Gesamtmoleküle geschaffen werden.

## Patentansprüche

1. Verfahren zur Herstellung einer Verbundvorrichtung mit folgenden Schritten:
Bereitstellen eines ersten Bauelements (10), auf dem ein erstes Molekül (14) aufgebracht ist, und eines zweiten Bauelements (20), auf dem ein zweites Molekül (24), das ausgebildet ist, um mit dem ersten Molekül (14) eine Bindung auszubilden, aufgebracht ist;
Einbringen des ersten Bauelements (10) und des zweiten Bauelements (20) in ein Hilfsfluid (110); und
Bewegen des Hilfsfluids (110), um das erste und/oder das zweite Bauelement (10, 20) in dem Hilfsfluid (110) zu bewegen, bis das erste Bauelement (10) und das zweite Bauelement (20) eine vorbestimmte, räumliche Beziehung aufweisen, wodurch das erste Molekül (14) und das zweite Molekül (24) die Bindung ausbilden, durch die das erste Bauelement (10) und das zweite Bauelement (20) mechanisch miteinander verbunden sind, und wobei
der Schritt des Bewegens einen Schritt des Erzeugens einer stehenden Welle oder eines Moire-Musters durch eine oder mehrere Schwingungsquellen, an einer Oberfläche des ersten Bauelements umfasst, so dass sich das zweite Bauelement an Orten verschwindender Geschwindigkeitsamplitude oder verschwindender Druckamplitude ablagert.

2. Verfahren gemäß Anspruch 1, bei dem das erste Molekül (14) ausgebildet ist, um mit einem weiteren ersten Molekül eine Bindung auszubilden, deren Bildungswahrscheinlichkeit kleiner oder dessen Zerfallswahrscheinlichkeit größer ist als die der Bindung zwischen dem ersten Molekül (14) und dem zweiten Molekül (24).

3. Verfahren gemäß Anspruch 1 oder 2, ferner mit folgenden Schritten:
Bereitstellen eines dritten Bauelements, auf dem ein drittes Molekül aufgebracht ist; und
Einbringen des dritten Bauelements in das Hilfsfluid, wobei auf dem zweiten Bauelement (20) ferner ein viertes Molekül aufgebracht ist, wobei das vierte Molekül ausgebildet ist, um mit dem dritten Molekül eine zweite Bindung auszubilden, und wobei eine Wahrscheinlichkeit für eine Ausbildung der ersten Bindung größer ist, als eine Wahrscheinlichkeit für eine Ausbildung einer Bindung zwischen dem ersten Molekül (14) und dem vierten Molekül und wobei eine Wahrscheinlichkeit für eine Ausbildung der zweiten Bindung größer ist, als eine Wahrscheinlichkeit für eine Ausbildung einer Bindung zwischen dem zweiten Molekül (24) und dem dritten Molekül,
wobei der Schritt des Bewegens ferner dafür vorgesehen ist, um das erste und/oder das zweite und/oder das dritte Bauelement (10, 20) zu bewegen, bis das zweite Bauelement (20) und das dritte Bauelement eine vorbestimmte räumliche Beziehung aufweisen, bei der das vierte Molekül und das dritte Molekül die weitere Bindung ausbilden, durch die das zweite Bauelement (20) und das dritte Bauelement mechanisch miteinander verbunden sind.

4. Verfahren gemäß Anspruch 3, bei dem das dritte Molekül ausgebildet ist, um mit dem ersten Molekül (14) eine Bindung auszubilden, deren Bildungswahrscheinlichkeit kleiner oder deren Zerfallswahrscheinlichkeit größer ist als die der weiteren Bindung zwischen dem dritten Molekül und dem vierten Molekül.

5. Verfahren gemäß einem der Ansprüche 1 bis 4, bei dem der Schritt des Bewegens einen Schritt des Einleitens von Gas in das Hilfsfluid (110) oder einen Schritt des Rührens oder Schwenkens oder einen Schritt des Heizens oder einen Schritt des Kühlens umfaßt.

6. Verfahren gemäß einem der Ansprüche 1 bis 5, bei dem der Schritt des Bewegens einen Schritt des Erzeugens einer Vibration umfaßt.

7. Verfahren gemäß einem der Ansprüche 1 bis 6, bei dem der Schritt des Bereitstellens einen Schritt des Aufdampfens des ersten Moleküls auf das erste Bauelement und/oder einen Schritt des Aufdampfens des zweiten Moleküls auf das zweite Bauelement umfaßt.

8. Verfahren gemäß einem der Ansprüche 1 bis 7, bei der das erste und das zweite Molekül (14, 24) organische oder anorganische Makromoleküle sind.

9. Verfahren gemäß Anspruch 8, bei der das erste und das zweite Molekül (14, 24) Peptide sind.

10. Verfahren gemäß Anspruch 8, bei der das erste und das zweite Molekül (14, 24) komplementäre DNA- oder RNA-Einzelstränge sind.

11. Verfahren gemäß einem der Ansprüche 1 bis 10, bei der das Gesamtmolekül durch eine Wasserstoffbrückenbindung oder eine Van-der-Waals-Bindung zwischen dem ersten Molekül (14) und dem zweiten Molekül (24) gebildet ist.

12. Verfahren gemäß einem der Ansprüche 1 bis 11, bei der das Gesamtmolekül eine leitfähige Verbindung zwischen dem ersten Bauelement (10) und dem zweiten Bauelement (20) bildet.

## Claims

1. Method for producing a composite apparatus, comprising:
providing a first device (10), a first molecule (14) is deposited on, and a second device (20), a second molecule (24 configured to form a bond with the first molecule (14) is deposited on;
introducing the first device (10) and the second device (20) into an auxiliary fluid (110); and
moving the auxiliary fluid (110) in order to move the first and/or the second device (10, 20) in the auxiliary fluid (110), until the first device (10) and the second device (20) have a predetermined spatial relation, whereby the first molecule (14) and the second molecule (24) form a bond whereby the first device (10) and the second device (20) are mechanically connected to each other, and wherein
the step of moving includes a step of generating a standing wave or a Moiré pattern by means of one or more oscillation sources, on a surface of the first device, so that the second device settles at locations of a vanishing velocity amplitude or a vanishing pressure amplitude.

2. Method of claim 1, wherein the first molecule (14) is configured to form a bond with a further first molecule, the forming probability of which is less than or the decomposition probability of which is greater than that of the bond between the first molecule (14) and the second molecule (24).

3. Method of claim 1 or 2, further comprising:
providing a third device, a third molecule is deposited on; and
introducing the third device into the auxiliary fluid, wherein on the second device (20) a fourth molecule is further deposited, the fourth molecule being configured to form a second bond with the third molecule, and wherein a probability for a forming of the first bond is greater than a probability for a forming of a bond between the first molecule (14) and the fourth molecule, and wherein a probability for a forming of the second bond is greater than a probability for a forming of a bond between the second molecule (24) and the third molecule,
wherein the step of moving is further provided in order to move the first and/or the second and/or the third device (10, 20) until the second device (20) and the third device have a predetermined spatial relation, wherein the fourth molecule and the third molecule form a further bond whereby the second device (20) and the third device are mechanically connected to each other.

4. Method of claim 3, wherein the third molecule is configured to form a bond with the first molecule (14), the forming probability of which is less than or the decomposition probability of which is greater than that of the further bond between the third molecule and the fourth molecule.

5. Method of any one of claims 1 to 4, wherein the step of moving includes a step of passing gas into the auxiliary fluid (110) or a step of stirring or swirling or a step of heating or a step of cooling.

6. Method of any one of claims 1 to 5, wherein the step of moving includes a step of generating a vibration.

7. Method of any one of claims 1 to 6, wherein the step of providing includes a step of vapor depositing the first molecule on the first device and/or a step of vapor depositing the second molecule on the second device.

8. Method of any one of claims 1 to 7, wherein the first and the second molecule (14, 24) are organic or inorganic macromolecules.

9. Method of claim 8, wherein the first and the second molecule (14, 24) are peptides.

10. Method of claim 8, wherein the first and the second molecule (14, 24) are complementary DNA or RNA single strands.

11. Method of any one of claims 1 to 10, wherein the total molecule is formed by a hydrogen bridge type bond or a van der Waals bond between the first molecule (14) and the second molecule (24).

12. Method of any one of claims 1 to 11, wherein the total molecule forms a conductive connection between the first device (10) and the second device (20).

## Revendications

1. Procédé pour produire un dispositif d'interconnexion, aux étapes suivantes consistant à:
préparer un premier composant (10) sur lequel est appliquée une première molécule (14), et un deuxième composant (20) sur lequel est appliquée une deuxième molécule (24) qui est réalisée de manière à former une liaison avec la première molécule (14);
introduire le premier composant (10) et le deuxième composant (20) dans un fluide auxiliaire (110); et
déplacer le fluide auxiliaire (110), pour déplacer le premier et/ou le deuxième composant (10, 20) dans le fluide auxiliaire (110), jusqu'à ce que le premier composant (10) et le deuxième composant (20) présentent un premier rapport spatial prédéterminé, d'où la première molécule (14) et la deuxième molécule (24) forment la liaison par laquelle le premier composant (10) et le deuxième composant (20) sont assemblés mécaniquement entre eux, et dans lequel
l'étape de déplacement comprend une étape consistant à générer une onde stationnaire ou un moirage par une ou plusieurs sources d'oscillation sur une surface du premier composant, de sorte que le deuxième composant se dépose à des endroits à amplitude de vitesse évanouissante ou à amplitude de pression évanouissante.

2. Procédé selon la revendication 1, dans lequel la première molécule (14) est réalisée de manière à former une liaison avec une autre première molécule dont la probabilité de formation est inférieure ou la probabilité de décomposition est supérieure à celle de la liaison entre la première molécule (14) et la deuxième molécule (24).

3. Procédé selon la revendication 1 ou 2, par ailleurs aux étapes suivantes consistant à:
préparer un troisième composant sur lequel est appliquée une troisième molécule; et
introduire le troisième composant dans le fluide auxiliaire, sur le deuxième composant (20) étant, par ailleurs, appliquée une quatrième molécule, la quatrième molécule étant réalisée de manière à former une deuxième liaison avec la troisième molécule, et une probabilité de formation de la première liaison étant supérieure à une probabilité de formation d'une liaison entre la première molécule (14) et la quatrième molécule et une probabilité de formation de la deuxième liaison étant supérieure à une probabilité de formation d'une liaison entre la deuxième molécule (24) et la troisième molécule,
l'étape de déplacement étant, par ailleurs, prévue pour déplacer le premier et/ou le deuxième et/ou le troisième composant (10, 20) jusqu'à ce que le deuxième composant (20) et le troisième composant présentent un rapport spatial prédéterminé dans lequel la quatrième molécule et la troisième molécule forment l'autre liaison par laquelle le deuxième composant (20) et le troisième composant sont assemblés mécaniquement entre eux.

4. Procédé selon la revendication 3, dans lequel la troisième molécule est réalisée de manière à former une liaison avec la première molécule (14) dont la probabilité de formation est inférieure ou la probabilité de décomposition est supérieure à celle de l'autre liaison entre la troisième molécule et la quatrième molécule.

5. Procédé selon l'une des revendications 1 à 4, dans lequel l'étape de déplacement comprend une étape consistant à introduire du gaz dans le fluide auxiliaire (110) ou une étape consistant à agiter ou à pivoter ou une étape consistant à chauffer ou une étape consistant à refroidir.

6. Procédé selon l'une des revendications 1 à 5, dans lequel l'étape de déplacement comprend une étape consistant à générer une vibration.

7. Procédé selon l'une des revendications 1 à 6, dans lequel l'étape de préparation comprend une étape consistant à déposer par vaporisation la première molécule sur le premier composant et/ou une étape consistant à déposer par vaporisation la deuxième molécule sur le deuxième composant.

8. Procédé selon l'une des revendications 1 à 7, dans lequel la première et la deuxième molécule (14, 24) sont des macromolécules organiques ou inorganiques.

9. Procédé selon la revendication 8, dans lequel la première et la deuxième molécule (14, 24) sont des peptides.

10. Procédé selon la revendication 8, dans lequel la première et la deuxième molécule (14, 24) sont des brins d'ADN ou d'ARN simple brin complémentaires.

11. Procédé selon l'une des revendications 1 à 10, dans lequel la molécule totale est formée par une liaison-pont d'hydrogène ou une liaison de Van der Waals entre la première molécule (14) et la deuxième molécule (24).

12. Procédé selon l'une des revendications 1 à 11, dans lequel la molécule totale forme une connexion conductrice entre le premier composant (10) et le deuxième composant (20).
